# FASCICULE DE BREVET EUROPEEN

(11) **EP 2 564 361 B1**
(45) Date de publication et mention de la délivrance du brevet: **20.09.2017**
(21) Numéro de dépôt: 11722902.1
(22) Date de dépôt: 21.04.2011
(51) Int. Cl.: G06K 19/077, B31F 1/07

(54) **INSERT FIBREUX CONSTITUÉ EN UNE SEULE COUCHE ET ÉQUIPÉ D'UN DISPOSITIF ÉLECTRONIQUE À COMMUNICATION SANS CONTACT**
FASERARTIG INLET GEBILDET IN EINE EINZIGE SCHICHT UND AUSGESTATTET MIT EINEM KONTAKTLOSEN ELEKTRONISCHE VORRICHTUNG
FIBER INLAY FORMED IN A SINGLE LAYER AND EQUIPPED WITH A CONTACTLESS ELECTRONIC

(30) Priorité: 28.04.2010 FR 1001815
(43) Date de publication de la demande: 06.03.2013
(73) Titulaire: ARJO SYSTEMS, 92100 Boulogne Billancourt (FR)
(72) Inventeur: LE LOARER, Thibaut, F-38260 Pommier de Beaurepaire (FR); MARLIN, Pascal, F-77120 Coulommiers (FR)
(74) Mandataire: Andrieux, Benoît
(86) Numéro de dépôt international: PCT/IB2011/051752
(87) Numéro de publication internationale: WO 2011/135497

(56) Documents cités:
- WO-A1-2007/046974
- WO-A2-01/45040
- US-A1- 2008 073 800
- US-A1- 2009 315 320

## Description

La présente invention concerne un insert plat destiné à être inséré dans un document de sécurité tel qu'un passeport, une carte d'identité, un permis de conduire... En particulier, l'insert comprend un support incluant un dispositif électronique à communication sans contact logé dans une cavité du support. Par exemple, le dispositif électronique est un dispositif d'identification radio fréquence dit « RFID » (« Radio Frequency Identification »).

Ce type d'insert muni d'un dispositif électronique à communication sans contact est de plus en plus répandu dans les documents de sécurité comme par exemple les documents identifiant les personnes. En effet, le dispositif électronique contient généralement dans sa mémoire des données relatives au porteur du document qui sont souvent encryptées. De tels inserts constituent donc une sécurité difficilement falsifiable par un fraudeur. Il en résulte un besoin croissant pour des inserts équipant ce type de documents.

Classiquement, la cavité destinée à recevoir le dispositif électronique peut être formée par un procédé mécanique de fraisage, lamage ou alésage, par perforation ou par l'utilisation d'un laser.

Ces procédés mécaniques consistent principalement à mettre en rotation un outil qui entre en contact avec la surface de l'insert et forme la cavité. La rotation de l'outil induit un fond de cavité qui n'est généralement pas plat et donc pas adapté à recevoir une puce qui elle, est sensiblement plate. En outre, un tel procédé mis en oeuvre sur un support fibreux entraîne un arrachage des fibres et une déformation de la cavité.

La perforation du support de l'insert, par exemple avec un outil emporte-pièce, forme une cavité traversant le support. Un insert muni d'une telle cavité ne permet pas une protection optimale de la puce qui est accessible et peut donc être soumise aux contraintes et/ou aux attaques, notamment mécaniques ou chimiques.

La formation d'une cavité au moyen d'un laser est relativement longue et coûteuse et ne permet pas d'atteindre des profondeurs suffisantes pour loger la puce dans le support de l'insert sans générer de surépaisseur. De plus, le laser brûle, endommage et noircie le matériau du support ce qui a pour effet de fragiliser le matériau du support au niveau de la cavité.

On connaît du document WO200507390 un insert en matériau plastique équipé d'un dispositif électronique à communication sans contact. L'insert est constitué d'au moins deux couches pour compenser l'épaisseur du dispositif électronique. Une des deux couches est munie d'une cavité traversant la couche et destinée à loger partiellement le dispositif électronique. L'autre partie du dispositif électronique est logée par compression dans l'autre couche de sorte à obtenir un dispositif électronique dont l'épaisseur est compensée par les deux couches. Le procédé d'obtention de cet insert est relativement long et coûteux puisqu'il nécessite un nombre important d'étapes. D'abord, les couches sont fabriquées, une des couches doit ensuite être perforée, le dispositif électronique est placé dans la cavité, enfin les deux couches doivent être laminées au repère pour former l'insert.

On connaît du document WO 2009046791 un insert en matériau thermoplastique qui est constitué d'une seule couche. L'insert est muni d'un dispositif électronique à communication sans contact logé dans une cavité traversante qui est formée dans l'insert. Un tel insert présente un certain nombre d'inconvénients. D'une part, le matériau thermoplastique est destiné à fondre sous l'action de la chaleur ce qui peut être très gênant étant donné que le procédé mécanique utilisé pour la formation de la cavité implique une élévation de la température dans la zone de formation de la cavité. Un tel matériau a donc tendance à fluer aléatoirement pendant l'opération de formation de la cavité. Il en résulte que la cavité présente des déformations et n'est donc pas adaptée pour loger le dispositif électronique. D'autre part, avec un tel insert, le dispositif électronique n'est pas protégé des attaques et contraintes extérieures, notamment mécaniques et chimiques, puisqu'il est accessible et apparent sur les deux faces de l'insert.

Le but de l'invention est donc de proposer un insert comprenant un dispositif électronique à communication sans contact qui ne présente pas les inconvénients mentionnés ci-dessus. Un autre but de l'invention est de proposer un insert qui soit simple et peu coûteux à fabriquer.

A cet effet, l'invention a pour objet un insert plat destiné à être inséré dans un document de sécurité, comprenant un support fibreux constitué en une seule couche muni d'une cavité et un dispositif électronique à communication sans contact logé dans ladite cavité, ladite cavité est débouchante sur une seule face du support et elle comprend en section transversale un épaulement périphérique pour loger ledit dispositif électronique dans ladite cavité sans générer de surépaisseur de l'insert.

L'insert selon l'invention est particulièrement bien protégé des attaques et contraintes extérieures, notamment mécaniques, puisque le dispositif électronique est logé dans une cavité ne débouchant que sur une face, c'est-à-dire que l'autre face est protégée par le matériau fibreux du support. En outre, cet agencement permet de maintenir le dispositif électronique dans le fond de la cavité. A l'inverse un dispositif électronique logé dans une cavité obtenue par perforation nécessiterait que le dispositif soit maintenu en place par exemple avant lamination avec une autre couche servant de support.

Selon un mode de réalisation particulier de l'invention, le dispositif électronique à communication sans contact est une puce module comprenant une puce encapsulée et un support de connexion sur lequel repose la puce encapsulée pour la connexion entre ladite puce et une antenne, le support de connexion étant disposé dans ledit épaulement périphérique de la cavité et la puce encapsulée étant disposée dans un fond de la cavité. L'épaulement périphérique est situé entre la face du support sur laquelle débouche la cavité et le fond de la cavité logeant la puce encapsulée. En conséquence, la puce module est complètement insérée dans la cavité et affleure la face débouchante du support. L'insertion de la puce module dans le support ne génère aucune surépaisseur. L'épaisseur de l'insert est donc constante.

En particulier, le dispositif électronique est choisi parmi les puces modules du type MOA2, MOB2, MOA4, MOB4, MOA6 et MOB6 commercialisées par la société PHILIPS, et MCC2, MCC8 commercialisées par la société INFINEON, et CID commercialisée par la société EM MICROELECTRONIC, et Cubit, IOA2, EOA2, EOA8, EOA9, FCP3 et NSL-1 micromodules.

Les puces modules par exemple du type MOx, MOB2, MOA2, MOB4, MOA4, MOB6 ou MOA6 commercialisées par la société Philips sont très répandues dans les applications sur les passeports électroniques et les cartes à puce en raison de leur stabilité mécanique sur le long terme. Elles présentent respectivement une épaisseur de 390 microns pour la MOA2 et la MOB2, 320 microns pour la MOA4 et la MOB4 et 260 microns pour la MOA6 et la MOB6. Les puces modules MOA2 et MOA4 présentent une surface généralement inférieure à 4 mm² alors que les puces modules MOB2 et MOB4 présentent une surface généralement supérieure à 4 mm².

De manière générale, une puce module comprend une puce à microcircuit encapsulée dans un boîtier isolant muni d'une ouverture à une extrémité. La puce à microcircuit est enrobée avec un produit plastique liquéfié et maintenue dans un moule permettant le durcissement du plastique. L'ouverture dans le boîtier permet la connexion de la puce à un support de connexion ou grille de connexion métallique s'étendant au-delà du boîtier. Ce support de connexion est découpé et relié à la puce encapsulée de sorte à former des bornes de connexion vers une antenne. La partie puce à microcircuit encapsulée de la puce module est encore appelée « potting » (remplissage) et le support de connexion « lead frame » (grille de connexion).

En section transversale la puce module se présente sous la forme d'un « T », avec la base de la forme en « T », moins large, qui correspond à la puce à microcircuit encapsulée et le haut de la forme en « T », plus large, qui correspond au support de connexion.

Selon un autre mode de réalisation particulier de l'invention, l'insert comprend une antenne filaire ou sérigraphiée disposée sur la face du support sur laquelle débouche la cavité, ladite antenne étant munie de deux extrémités connectées au support de connexion pour une communication sans contact.

L'antenne filaire ou sérigraphiée est agencée en bobine pour former au moins une spire.

Selon un autre mode de réalisation particulier de l'invention, l'insert comprend une ou plusieurs des caractéristiques suivantes :
- le support fibreux est formé d'au moins 30 % de fibres naturelles telles que des fibres cellulosiques et/ou des fibres de coton, avec une proportion de fibres courtes moins élevée que de fibres longues,
- le support fibreux comprend un liant choisi parmi les polymères thermoplastique de Tg compris entre -25 °C et 40°C, le liant est de préférence précipité en masse et de préférence choisi parmi un copolymère styrène butadiène, un polymère acrylique, un acétate de vinyle et leurs copolymères, un latex, un composé d'amidon, un composé de charge minérale ou un mélange de ces derniers,
- le support fibreux comporte un agent assouplissant de préférence choisi parmi la glycérine, l'urée ou l'urée nitrate,
- le support fibreux comprend entre 8 et 15 % de fibres synthétiques, en masse dans la base fibreuse du support, par exemple les fibres synthétiques sont choisies parmi des matières thermoplastiques telles qu'un polyamide, un polyester, une polyoléfine et/ou un mélange de telles fibres,
- le support fibreux comprend une charge choisie parmi des charges minérales, notamment les carbonates, en particulier de calcium, le talc, le kaolin, l'hydrate d'alumine, le dioxyde de titane, le silicate de sodium et leurs mélanges, la charge étant de préférence une charge absorbante ayant une capacité d'absorption supérieure ou égale à 30 ml/100g.

L'invention s'étend à un document de sécurité tel qu'un passeport, une carte d'identité, un permis de conduire, une carte à jouer ou à collectionner interactive, un moyen de paiement, notamment une carte de paiement, un bon d'achat ou un voucher, une carte de transport, une carte de fidélité, une carte de prestation ou une carte d'abonnement, incluant l'insert. Dans le cas du passeport, la couverture et/ou le livret peuvent être équipés de l'insert.

L'invention s'étend également à un procédé pour fabriquer un insert plat destiné à être inséré dans un document de sécurité, le procédé comprend les étapes consistant à :
- fournir un support fibreux,
- former une cavité dans ledit support par compression au moyen d'une pièce présentant un épaulement de sorte que ladite cavité est débouchante sur une seule face du support et qu'elle présente en section transversale un épaulement périphérique,
- loger un dispositif électronique dans ladite cavité sans générer de surépaisseur de l'insert.

L'insert obtenu par un tel procédé de fabrication est équipé d'une cavité débouchante sur une seule face. Elle ne traverse donc pas le support de part en part. Cette cavité ne traverse donc pas le support de l'insert. L'insert obtenu par le procédé de fabrication selon l'invention est ainsi protégé des attaques et contraintes extérieures et maintenu en place dans le fond de la cavité.

La cavité réalisée dans le support fibreux présente en section transversale une forme en « T » correspondant à celle du dispositif électronique. De plus, l'épaisseur du support est de préférence supérieure à l'épaisseur du dispositif électronique de sorte que l'insert avec le dispositif électronique dans la cavité présente une épaisseur constante sur toute sa surface.

Selon un mode de réalisation particulier de l'invention, l'étape de formation de ladite cavité dans ledit support est réalisée par compressions répétées à une fréquence ultrasonore au moyen de la pièce présentant un épaulement. De préférence la fréquence ultrasonore est comprise entre 20 kHz et 1 Méga Hz.

Selon un autre mode de réalisation particulier de l'invention, l'étape de formation de ladite cavité dans ledit support est réalisée par thermocompression ou par emboutissage.

Selon encore un mode de réalisation particulier de l'invention, on fournit un dispositif électronique qui est une puce module comprenant une puce encapsulée et un support de connexion sur lequel repose la puce pour la connexion entre ladite puce et une antenne. Le procédé comprend en outre une étape consistant à disposer le support de connexion dans ledit épaulement périphérique de la cavité et la puce encapsulée dans un fond de la cavité.

Selon encore un mode de réalisation particulier de l'invention, le procédé comprend en outre une étape consistant à disposer une antenne filaire ou sérigraphiée sur la face du support sur laquelle débouche la cavité, la dite antenne étant munie de deux extrémités connectées au support de connexion pour une communication sans contact.

Selon un autre mode de réalisation particulier de l'invention, le procédé comprend une ou plusieurs des étapes suivantes :
- fournir le support fibreux avec au moins 30 % de fibres naturelles telles que des fibres cellulosiques et/ou des fibres de coton avec une proportion de fibres courtes moins élevées que de fibres longues,
- fournir le support fibreux avec un liant choisi parmi les polymères thermoplastique de Tg compris entre -25 °C et 40°C, le liant est de préférence précipité en masse et de préférence choisi parmi un copolymère styrène butadiène, un polymère acrylique, un acétate de vinyle et leurs copolymères, un latex, un composé d'amidon, un composé de charge minérale ou un mélange de ces derniers,
- fournir le support fibreux avec un agent assouplissant de préférence choisi parmi la glycérine, l'urée ou l'urée nitrate,
- fournir le support fibreux avec entre 8 et 15 % de fibres synthétiques, en masse dans la base fibreuse, par exemple les fibres synthétiques sont choisies parmi des matières thermoplastiques telles qu'un polyamide, un polyester, une polyoléfine et/ou un mélange de telles fibres,
- fournir le support fibreux avec une charge choisie parmi des charges minérales, notamment les carbonates, en particulier de calcium, le talc, le kaolin, l'hydrate d'alumine, le dioxyde de titane, le silicate de sodium et leurs mélanges, la charge étant de préférence une charge absorbante ayant une capacité d'absorption supérieure ou égale à 30 ml/100g.

Ces caractéristiques du support fibreux confèrent à l'insert une compressibilité particulièrement adaptée à des étapes de compressions répétées à une fréquence ultrasonore. En effet, avec un tel support fibreux, il est possible selon l'invention de réaliser une cavité d'une profondeur suffisante pour loger le dispositif électronique sans que le matériau du support ne se déforme sur la face sur laquelle la cavité n'est pas débouchante. Le support reste plat sur cette face.

Un exemple de réalisation de l'invention est décrit plus en détail ci-après et illustré par les figures. Cette description n'est donnée qu'à titre d'exemple indicatif et nullement limitatif de l'invention.
La figure 1 illustre schématiquement un insert selon l'invention vu de dessus.
La figure 2 illustre schématiquement l'insert selon l'invention dans une vue en coupe transversale partielle selon l'axe A-A de la figure 1.
Les figures 3 a) à d) illustrent de manière schématique les différentes étapes du procédé de fabrication de l'insert selon l'invention avec le support fibreux vu en coupe partiel.

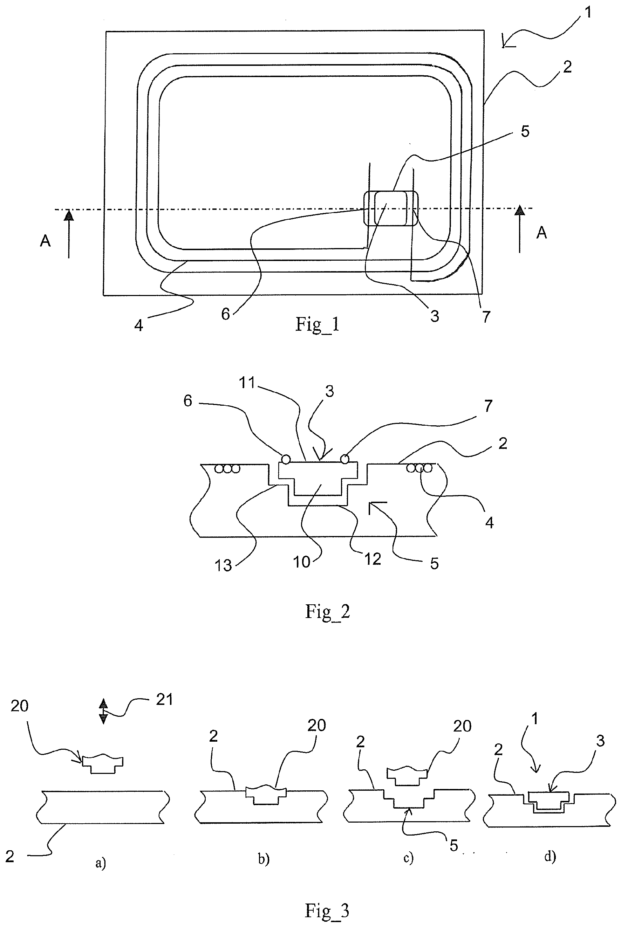

Sur la figure 1, on montre un insert 1 plat selon l'invention comprenant principalement un support fibreux 2 un dispositif électronique à communication sans contact 3 et une antenne 4.

Le support fibreux 2 est constitué en une seule couche et muni d'une cavité 5 apte à recevoir le dispositif électronique à communication sans contact 3 sans générer de surépaisseur de l'insert.

Dans l'exemple de réalisation des figures 1 et 2, l'antenne 4 est une antenne filaire, par exemple constituée d'un fil de cuivre entouré d'une gaine isolante sauf sur ses extrémités de connexion 6 et 7. Comme illustré sur la figure 1, l'antenne 4 est déposée sur une face du support fibreux 2 de sorte à former une pluralité de spires concentriques autour du dispositif électronique auquel sont soudées les extrémités de connexion 6 et 7 de l'antenne 4. L'antenne et le dispositif connectés ensemble forment un transpondeur et l'insert 1 ainsi constitué est apte à communiquer avec des signaux radio-fréquences, par exemple avec un lecteur externe, grâce au dispositif électronique 3 qui génère ou reçoit des signaux via l'antenne 4. Alternativement, l'antenne peut être obtenue par dépose d'une encre conductrice par un procédé de sérigraphie sur la face du support de l'insert.

Sur la figure 2, on montre le détail de l'insert 1 selon l'invention avec le dispositif électronique 3 inséré dans la cavité 5 et l'antenne 4 connectée au dispositif électronique 5.

Le dispositif électronique 3 est de préférence une puce module comprenant une puce à microcircuit encapsulée 10 et un support de connexion 11. La puce encapsulée 10 est fixée au support de connexion 11 de sorte à former un « T ». La base de la forme en « T », moins large, qui correspond à la puce encapsulée 10 et le haut de la forme en « T », plus large, qui correspond au support de connexion 11.

En particulier, le dispositif électronique est choisi parmi les puces modules du type MOA2, MOB2, MOA4, MOB4, MOA6 et MOB6 commercialisées par la société PHILIPS.

Dans le cas d'une puce module MOB4 l'épaisseur de la puce encapsulée est d'environ 200 microns et d'environ 130 microns pour une puce module MOB6. Pour ces deux puces modules le support de connexion présente une épaisseur d'environ 130 microns. Le support de connexion 11 présente une longueur plus importante que la puce encapsulée 10 ce qui induit la forme en « T » en section transversale. Leurs largeurs sont sensiblement équivalentes.

La cavité 5 présente, en section transversale, un fond 12 et un épaulement périphérique 13. L'épaulement périphérique 13 est situé entre la face du support 2 sur laquelle débouche la cavité 5, dans l'exemple de la figure 2 la face supérieure, et le fond 12 de la cavité logeant la puce encapsulée 10. Les dimensions de la cavité 5 correspondent sensiblement à celles de la puce module 3 de sorte à faciliter l'insertion de cette dernière.

En outre un adhésif peut être déposé sur l'épaulement périphérique 13 de la cavité 5 pour rendre le support fibreux 2 et la puce module 3 solidaires.

On montre sur la figure 2 que le support de connexion 11 de la puce module 3 vient à affleurement de la surface du support. En conséquence, la puce module 3 est entièrement logée dans le support 2 et l'insert 1 selon l'invention présente une épaisseur constante sur toute sa surface. Comme détaillé ci-après, l'épaisseur constante de l'insert rend la détection de la puce module plus difficile renforçant ainsi la sécurité du document de sécurité dans lequel l'insert est disposé.

De plus avec un tel agencement et une épaisseur du support 2 supérieure à celle de la puce 5, la cavité 5 ne débouche que sur une face du support plat 2, elle ne traverse pas le support. La puce module 3 est donc protégée et maintenu en place sur l'autre face par une couche de matière fibreuse.

L'antenne 4 illustrée sur la figure 2 est par exemple déposée dans le support 2 par un procédé de thermocompression ou par un procédé par ultrason. L'antenne 4 pénètre donc dans le support fibreux 2 pour en être solidaire et ne génère aucune surépaisseur de l'insert 1. De ce fait, elle est totalement protégée et l'insert selon l'invention peut être manipulé facilement.

Les extrémités conductrices 6 et 7 de l'antenne 4 sont respectivement soudées à deux bornes électriquement isolées du support de connexion 11 de la puce module 3.

Sur la figure 3, on illustre par quatre étapes a) à d) le procédé selon l'invention pour la fabrication d'un insert plat destiné à être inséré dans un document de sécurité.

Dans la première étape du procédé on fournit un support fibreux obtenu au moyen d'une machine à papier du type table plate ou forme ronde. De préférence, le support fibreux est constitué d'au moins 30 % de fibres naturelles telles que des fibres cellulosiques et/ou des fibres de coton avec une proportion de fibres courtes moins élevées que de fibres longues.

De préférence, la base fibreuse du support 2 comporte également des fibres synthétiques. Par exemple, les fibres synthétiques sont choisies parmi des fibres d'une matière thermoplastique, notamment d'un polyamide, d'un polyester, d'une polyoléfine et/ou un mélange de telles fibres.

La base fibreuse comporte préférentiellement entre 8 et 15 % de fibres synthétiques, en masse dans la base fibreuse.

La teneur massique en fibres synthétiques dans la base fibreuse peut être évaluée par exemple par une mesure tridimensionnelle par stéréologie sur coupe bidimensionnelle au microscope électronique à balayage.

L'utilisation de fibres synthétiques dans la base fibreuse apporte les propriétés suivantes : résistances à la déchirure et à la traction élevées, flexibilité et stabilité dimensionnelle, ce qui évite qu'une trop grande variation dimensionnelle du support et une modification inacceptable des fréquences de fonctionnement du dispositif électronique. Avantageusement, la présence de telles fibres synthétiques facilite la compression du support fibreux 2 par déplacement des fibres synthétiques sans fluage ou déformation ce qui est particulièrement adapté à la formation de la cavité. L'insertion de l'antenne par thermocompression ou par ultrason en est également facilitée.

De préférence, la base fibreuse du support 2 comporte également un liant. Par exemple, le liant peut être un copolymère styrène butadiène, un polymère acrylique, un acétate de vinyle et leurs copolymères, un latex, un composé d'amidon, un composé de charge minérale ou un mélange de ces derniers. Le liant présente une température de transition vitreuse Tg comprise entre -25 °C et 40°C, de préférence 5°C. Une base fibreuse particulièrement adaptée comprend un latex acrylique, de l'urée nitrate, 15% fibres synthétiques, par exemple à base de 7,5% de PET et 7,5% de PA, dont la longueur est de 6mm, le diamètre de 1,7dtex, 85% de fibres naturelles, par exemple à base de cellulose, dont 80% de fibres longues et 20% de fibres courtes, et 13% en masse de kaolin et environ 5 % de dioxyde de titane TiO2.

Le liant de la base fibreuse est par exemple introduit dans la base fibreuse par surfaçage, par exemple au moyen d'une presse encolleuse (« size press »). Alternativement, les fibres de la base fibreuse sont liées avec un liant précipité en masse.

Le liant de la base fibreuse est éventuellement associé à un agent assouplissant. Ce dernier peut être choisi parmi la glycérine, l'urée ou l'urée nitrate.

La présence d'un liant souple en masse ou en surface de la base fibreuse souple et éventuellement d'un agent assouplissant apporte les propriétés suivantes : flexibilité, cohésion interne pour offrir à l'insert la résistance à la délamination suffisante, effet bouche porage pour maintenir à la surface du support flexible la couche de surface à base de liant de couchage et de charges.

De préférence, la base fibreuse du support 2 comporte également des charges. Par exemple, les charges sont choisies parmi des charges minérales, notamment les carbonates, en particulier de calcium, le talc, le kaolin, l'hydrate d'alumine, le dioxyde de titane, le silicate de sodium et leurs mélanges. Les charges sont de préférence des charges absorbantes ayant une capacité d'absorption supérieure ou égale à 30 ml/100g. La base fibreuse peut comporter entre 8 et 20% en poids de charge minérale. Une quantité trop importante de charge par exemple >25% peut ne pas être adaptée à la compression à une fréquence ultrasonore car les charges « absorbent » ces fréquences qui ne sont alors plus transmise au support fibreux pour la formation de cavité, ou qui ne permettent plus de former la cavité à une profondeur suffisante pour loger le dispositif électronique. De plus, l'augmentation du taux de charge peut engendrer une augmentation de la densité et donc une diminution de la compressibilité.

La présence de charges permet d'améliorer la stabilité dimensionnelle du support et donc d'améliorer la stabilité du dispositif électronique et de l'antenne lors d'un processus ultérieure de lamination à chaud du support fibreux avec une autre couche par exemple pour former une structure multicouches.

Avantageusement, la présence de fibres synthétiques, d'un liant et de charges minérales au moins à la surface du support facilite grandement une insertion par enfoncement. Le support fibreux est donc particulièrement adapté au procédé de fabrication tel que décrit ci-après.

En effet, le liant et les charges présentent un comportement à la température et une rigidité suffisante, qui peut être quantifiée par un niveau de force d'arrachage minimal, et un niveau de pénétration dans le support fibreux satisfaisant qui limite les surépaisseurs locales sur l'insert.

Un couchage à base de liant polymère thermoplastique et de charges minérales au moins à la surface du support sur lequel est formé la cavité procure une énergie de surface et une capacité d'absorption plus élevées du support, qui favorisent l'étalement et la pénétration d'un adhésif, et donc l'adhérence ultérieure de l'adhésif activable à chaud, utilisé dans le processus d'assemblage du support de l'insert avec une autre couche mais aussi l'assemblage ultérieur par collage à froid ou à chaud de l'insert avec d'autres matériaux, par exemple une couverture et une page de garde d'un livret de passeport, tout en offrant une sécurité satisfaisante en cas de tentative de séparation de l'ensemble.

Dans un exemple de mise en oeuvre, la base fibreuse du support fibreux est liée avec un polymère synthétique précipité en masse de Tg< 20 °C et par exemple avec un polymère souple de Tg de l'ordre de -20 °C, qui peut être précipité un situ sur les fibres selon des procédés connus dans l'état de l'art.

Dans un autre exemple de mise en oeuvre, la base fibreuse du support fibreux est liée avec un polymère synthétique de Tg< 20 °C introduit par surfaçage « size press » ou par imprégnation et par exemple avec un polymère souple de Tg de l'ordre de 7 °C, qui offre à la fois souplesse et faible encrassement des rouleaux de « size press » ou d'imprégnatrice. Ce liant peut être associé à un agent assouplissant tel que l'urée nitrate pour accroître encore la souplesse du support flexible.

Dans un autre exemple de mise en oeuvre, la base fibreuse du support fibreux est liée avec un liant naturel hydrophile tel que par exemple l'alcool polyvinylique ou l'amidon, introduit par surfaçage « size presse » ou par imprégnation. Ce liant peut être additionné d'agent assouplissant, par exemple de glycérine, pour accroître la souplesse du support flexible.

Dans un exemple de mise en oeuvre de l'invention, le support de l'insert présente au moins sur l'une de ses faces une enduction comprenant un liant thermoplastique et des charges minérales. Ce liant pourra être choisi parmi les liants synthétiques, incluant les polymères ou les copolymères acryliques, vinyliques, styrène butadiène, styrène butadiène acrylonitrile.

Les exemples de support fibreux 1 à 6 décrits ci-dessous sont particulièrement adaptés à la fabrication de l'insert selon l'invention.

### Exemple 1

Le support fibreux est fabriqué sur la machine à papier de façon à ce que le support comprenne une base fibreuse composée d'environ 15% sec en masse par rapport au papier fini de fibres synthétiques en polyamide, d'environ 6 mm de longueur et d'environ 1.7 dtex de diamètre, et d'environ 56 % de fibres cellulosiques. Les fibres cellulosiques sont composées de 80 % en nombre des fibres longues (issues de feuillus) et de 20 % en nombre de fibres courtes (issues de résineux).

Le support comprend aussi environ 13 % en poids par rapport au papier fini d'au moins une charge minérale, introduite soit au raffinage, soit plus tard en mélangeuse. La charge minérale est par exemple du kaolin.

La base fibreuse après formation en feuille est surfacée sur la machine à papier par un système de « size press ». Le bain de « size press » contient un liant, par exemple du polyvinyl alcool, à hauteur de 4 % en poids sec par rapport au bain, un agent assouplissant, par exemple de la glycérine à hauteur de 15 % en poids sec par rapport au bain, et des pigments, par exemple du kaolin à hauteur de 4 % en poids sec par rapport au bain, soit un extrait sec final de 23 %.

Lors de l'imprégnation en « size press », le papier est imprégné d'environ 40 g/m² de bain humide, soit une reprise sèche d'environ 9 g/m² sec.

La base fibreuse est ensuite enduite sur ses deux faces par le biais d'une coucheuse lame d'air, avec une sauce de couchage comprenant 30 parts de liant de couchage de type styrène acrylique et 100 parts d'un mélange de pigments à base de carbonate de calcium, hydrate d'alumine et silicate de sodium.

La dépose de couche sur le support est de l'ordre de 10 g/m² sec par face, par exemple.

Ce support enduit offre une bonne résistance à la déchirure grâce à la présence des fibres synthétiques de 6 mm. Il offre aussi une certaine flexibilité du fait de la présence des fibres synthétiques, des charges en masse et en surface, et de la glycérine.

Enfin, de par la présence de la couche de surface comprenant au moins un liant thermoplastique, il offre une bonne aptitude à l'insertion d'une antenne par ultrasons ainsi que, du fait de la présence de charges dites absorbantes comme le silicate et l'hydrate d'alumine, une capacité d'absorption et une énergie de surface favorables à un contrecollage ultérieur.

### Exemple 2

Le support fibreux est de même formulation que dans l'exemple 1, à l'exception de l'absence de charges en masse et d'une modification du bain de la « size press » qui contient un liant de couchage, par exemple du PVA à hauteur de 4 % en poids sec par rapport au bain, un agent assouplissant, par exemple de la glycérine à hauteur de 15 % en poids sec par rapport au bain et un produit de collage de surface de base acrylique à hauteur de 4 % en poids commercial par rapport au bain.

La flexibilité du support fibreux obtenue est un peu plus faible que dans l'exemple précédent du fait de l'absence de charges mais la résistance à la falsification par pelage ainsi que la cohésion du support sont améliorées car la cohésion interne est plus élevée.

### Exemple 3

Le support fibreux est de même formulation que dans l'exemple 1, à l'exception du bain de « size press » qui est remplacé par un bain d'imprégnatrice comprenant uniquement un latex souple comme liant, par exemple un latex styrène acrylique de Tg égale à 5 °C, qui permet de conférer à la fois de la souplesse et de la cohésion au support.

### Exemple 4

Le support fibreux est de même formulation que dans l'exemple 3, à l'exception du bain de « size press » qui comprend de l'urée nitrate comme agent assouplissant en plus du latex souple comme liant de la base fibreuse, d'où encore plus de flexibilité.

### Exemple 5

Le support fibreux est de même formulation que dans l'exemple 3, mais le liant de la base fibreuse est introduit par précipitation des particules de liant in situ sur les fibres, lors de la formation de la feuille, de façon à conférer de la souplesse au support.

Les particules de liant sont par exemple des particules de latex chargées anioniquement, qui précipitent par interactions ioniques sur des fibres portant des charges cationiques.

Les fibres de cellulose étant chargées anioniquement, des additifs tels que la polyamideamine épichlorhydrine peuvent être fixés au préalable sur les fibres pour modifier leur charge.

Les particules de latex de Tg faible, inférieure à -10°C, apportent de la souplesse au matériau tout en n'engendrant pas de problème d'encrassement dans l'imprégnatrice.

Si le taux de latex introduit dans la base fibreuse est suffisamment élevé, par exemple d'au moins 20 % en masse dans la base fibreuse le surfaçage du support peut être réalisé avec d'autres liants de surface, par exemple un PVA, et ce liant n'aura pas tendance à rigidifier le support.

Le support fibreux plat obtenu selon l'un des exemples précédents est suffisamment flexible pour être compatible avec la rigidité du document dans lequel il est intégré. Un tel support est apte à protéger mécaniquement le dispositif électronique et l'antenne des contraintes mécaniques de type impact, flexion ou torsion.

Un tel support fibreux 2 est en outre particulièrement adapté à la formation d'une cavité par compression qui est destinée à recevoir un dispositif électronique à communication sans contact.

Sur la figure 3 a), on montre le support fibreux 2 obtenu selon l'un des exemples décrits ci-dessus et la tête 20 d'un transducteur à ultrasons.

De manière générale, les ultrasons sont des ondes élastiques dont la fréquence est comprise entre 20 kHz et environ 1 Mégahertz. La propagation des ultrasons dans le support fibreux 2 se caractérise par des vibrations induisant un échauffement de la matière et sa densification. Le support fibreux tel que décrit ci-avant présente un taux de compressibilité compris entre 50 et 80%. Sa composition est donc spécialement adaptée pour que l'échauffement de la matière et sa densification ne provoque pas de déformation aléatoire du support mais forme une cavité correspondant à la tête 20.

De nombreux systèmes sont susceptibles de produire des ultrasons. Un appareil produisant des ultrasons est communément appelé transducteur ou convertisseur ultrasons. La technologie des transducteurs peut être basée sur des générateurs pneumatiques, électrodynamiques ou électriques. Dans ce dernier cas, on utilise les propriétés des matériaux magnétostrictifs ou piézoélectriques pour convertir l'énergie électrique en une énergie mécanique ultrasonore. De préférence on utilisera des matériaux piézoélectriques.

Classiquement, un transducteur à ultrason est composé de deux parties principales :
- le convertisseur ultrasons qui est excité à sa fréquence de résonance. Il est constitué de céramiques piézoélectriques comprises entre le pavillon et la contremasse pour convertir l'énergie électrique en vibrations mécaniques.
- la sonotrode ou tête de compression 20 du transducteur qui transmet la vibration mécanique au milieu.

La tête 20 du transducteur à ultrasons est conçue pour former la cavité 5 dans le support fibreux 2 de préférence par compressions répétées à une fréquence ultrasonore. A cet effet, la tête 20 est une pièce présentant un épaulement périphérique complémentaire de celui de la cavité 5 décrite en référence à la figure 2.

En particulier, la tête du transducteur 20 présente une forme en « T ». La base de la forme en « T », moins large, correspond, en dimensions, à la puce encapsulée 10 et le haut de la forme en « T », plus large, correspond, en dimensions, au support de connexion 11.

Le transducteur à ultrasons (non montré) est disposé de manière à ce que la tête 20 soit dirigée avec la base de la forme en « T » orientée vers une face du support fibreux 2. Il est à noter que le support fibreux repose sur un support fixe non montré. Le transducteur à ultrasons est en outre agencé pour déplacer la tête 20 selon un mouvement alternatif de va-et-vient constituant des vibrations à une fréquence ultrasonore. Ce mouvement est orienté selon la direction indiquée par la flèche 21 qui est sensiblement perpendiculaire à la face du support fibreux 2. Le déplacement maximal de la tête 20 est obtenu à certaines fréquences de résonances qui dépendent de la géométrie du transducteur. De préférence, la fréquence de résonance est comprise entre 20kHz et 70kHz et de manière encore préférée entre 20kHz et 40kHz.

En fonctionnement, lorsqu'une tension électrique est appliquée sur les deux électrodes de la céramique piézoélectrique du transducteur, le matériau se dilate ou se comprime selon l'orientation de la tension par rapport à la polarisation de la céramique. L'alternance du champ électrique, entraîne le passage d'une dilatation à une compression de sorte à créer le mouvement alternatif de va-et-vient.

La tête 20 du transducteur pénètre donc dans le support fibreux 2 à une fréquence ultrasonore comme cela est illustré sur la figure 3 b). Le support fibreux 2 est ainsi densifié par compression de sorte à former la cavité 5 comme illustré sur la figure 3 c). La tête 20 du transducteur pénètre dans le support fibreux 2 jusqu'à une profondeur suffisante pour loger le dispositif électronique à communication sans contact sans générer de surépaisseur de l'insert et sans traverser le support fibreux.

A l'issue du processus de compressions répétées, la cavité 5 formée correspond parfaitement et sans déformation au dispositif électronique 3, par exemple une puce module. De plus, le support fibreux 2 n'est pas endommagé ou fragilisé dans la zone où la cavité est formée. On introduit alors le dispositif électronique à communication sans contact 3 dans la cavité 5 à l'étape illustrée par la figure 3 c), par exemple au moyen d'un outil preneur-poseur.

Avantageusement, la formation de la cavité 5 par compressions répétées à une fréquence ultrasonore ne nécessite qu'un temps très court, inférieure à 0,5 seconde. En outre, la fabrication du transducteur est simple et peu coûteuse. Enfin, le dispositif électronique 3 est logé dans un support fibreux formé en une seule couche, c'est-à-dire en évitant une étape de lamination entre deux couches, et sans générer de surépaisseur de l'insert.

Par exemple, pour la fabrication d'un insert 1 incorporant un dispositif électronique d'épaisseur 330 microns, le support fibreux est fabriqué avec une épaisseur de 415 microns et suffisamment compressible pour que le procédé selon l'invention décrit ci-dessus permette de réaliser une cavité correspondant au dispositif électronique et présentant une profondeur d'au moins 330 microns.

Dans cet exemple de réalisation, une épaisseur de 85 microns sépare le fond de la cavité de la face opposée à la face sur laquelle débouche la cavité. En raison de la composition du support fibreux, cette face opposée n'est pas non plus déformée pendant le processus de formation de la cavité. La face opposée présente l'intérêt de maintenir le dispositif électronique en place et de le protéger.

Alternativement, dans un processus de fabrication en ligne, le support fibreux 2 peut être déplacé en bande entre un rouleau rotatif et la tête d'un transducteur. Dans ce cas, il peut être prévu que le rouleau rotatif présente sur sa périphérie une ou plusieurs saillies formant un « T » en section transversale et que la tête du transducteur soit plate. Les saillies en forme de « T » sont alors réparties régulièrement sur la périphérie du rouleau rotatif de sorte à former des cavités dans le support fibreux avec un pas régulier correspondant à l'intervalle désiré entre chaque insert 1 et/ou aux dimensions des inserts. En fonctionnement, la tête du transducteur exerce des compressions répétées à une fréquence ultrasonore sur le support fibreux en bande qui est lui-même pris en sandwich entre cette tête et le rouleau rotatif équipé des saillies en forme de « T ». Il en résulte que les formes en « T » pénètrent dans le support fibreux pour former en continu des cavités dans le support en bande. Le dispositif électronique est ensuite déposé dans la cavité par exemple par un procédé preneur-poseur.

Ultérieurement aux étapes de fabrication de l'insert illustrées sur les figures 3 a) à d), un fil d'antenne peut être fixé sur le support fibreux par exemple par compression, par thermocompression, par ultrason ou par collage, grâce à un adhésif présent sur le support. Dans le cas de l'utilisation d'un adhésif, ce dernier peut être réticulable sous un rayonnement UV. L'adhésif est alors soumis à l'exposition aux UV en même temps ou juste avant que le fil d'antenne soit déroulé sur le support fibreux, la source UV étant par exemple portée par un outil de dépose du fil.

La technique d'insertion par ultrasons de l'antenne permet, elle, une pénétration du fil d'antenne avec fusion locale de la matrice du support fibreux, l'insertion par pression du fil d'antenne dans ce support et son maintien sur le support après refroidissement. Cette technique peut être mise en oeuvre au moyen d'un transducteur et d'une sonotrode tels que décrits précédemment.

Alternativement, l'antenne peut être déposée selon un procédé d'impression d'argent en sérigraphie sur le support fibreux.

Alternativement, la cavité peut être formée dans le support fibreux par un procédé de thermocompression ou par emboutissage.

L'insert selon l'invention incluant le dispositif électronique peut ensuite être associé à d'autres couches fibreuses ou non, par exemple par lamination à chaud, de sorte à former une structure multicouches.

L'insert selon l'invention ou la structure multicouches incluant l'insert peuvent ensuite être insérés dans un document de sécurité ou constituer un élément de ce dernier.

Par exemple, l'insert est pris en sandwich entre deux autres supports que sont la couverture et la page de garde du livret dans le cas d'un passeport ou deux films plastiques ou papiers dans le cas d'une carte, par exemple une carte d'identité. Dans les deux cas, l'insert présente sur ses faces extérieures une énergie de surface assez élevée et une capacité d'absorption suffisante pour favoriser l'assemblage par collage de l'insert avec d'autres substrats. Par exemple, l'une des couches est enduite d'un adhésif réactif à chaud, par exemple à base de polyuréthane, qui offrira après assemblage avec l'autre couche et lamination à chaud, toutes les qualités attendues notamment d'inviolabilité pour prévenir tout enlèvement du dispositif RFID par un fraudeur en vue de l'utiliser dans un autre document. L'insert ainsi réalisé offre une bonne résistance aux tentatives de falsification à sec, à chaud et dans les solvants, présente une bonne flexibilité et une cohésion suffisante pour prévenir toute délamination spontanée. Par ailleurs, cet insert présente les qualités de surface convenant à un collage avec une colle froide vinylique ou acrylique telle qu'utilisée actuellement pour l'intégration entre la couverture et la page de garde d'un livret de passeport.

Dans le cas d'un document de sécurité pliable tel qu'un passeport à deux volets par exemple, il peut également être prévu que l'insert recouvre toute la couverture et que le dispositif électronique 3 et l'antenne 4 soient disposés de manière à ne s'étendre que sur partie de l'insert correspondant à un des deux volets. Il peut également être prévu qu'une rainure faisant charnière soit formée au milieu de l'insert de sorte à séparer les deux volets et à faciliter le pliage du passeport. La rainure est alors formée par une tête de transducteur adaptée en dimension et qui pénètre dans le support fibreux à une fréquence ultrasonore. Le support fibreux est ainsi densifié par compression pour former la rainure. Alternativement, la rainure est formée par enlèvement de matière.

L'invention s'étend donc à tout document de sécurité de sécurité incluant l'insert, tel qu'un passeport, une carte d'identité, un permis de conduire, une carte à jouer ou à collectionner interactive, un moyen de paiement, notamment une carte de paiement, un bon d'achat ou un voucher, une carte de transport, une carte de fidélité, une carte de prestation ou une carte d'abonnement.

Un document de sécurité ainsi obtenu comporte donc au moins un dispositif électronique à communication sans contact dont la mémoire peut être lue par un lecteur adapté ce qui constitue un élément de sécurité dit « de troisième niveau ». Il peut toutefois comporter d'autres éléments de sécurité « de premier niveau » et/ou au moins un élément de sécurité dit « de deuxième niveau » et/ou « de troisième niveau ».

Le document peut en particulier comporter les éléments de sécurité suivants seuls ou en combinaison :
- des colorants et/ou des pigments luminescents et/ou des pigments interférentiels et/ou des pigments à cristaux liquides, notamment sous forme imprimée ou mélangée à au moins une couche constitutive du document,
- des composants, colorants et/ou des pigments photochromes ou thermochromes, notamment sous forme imprimée ou mélangée à au moins à au moins une couche constitutive du document,
- un absorbeur ultraviolet (UV), notamment sous forme enduite ou mélangée à au moins à au moins une couche constitutive du document,
- un matériau spécifique collecteur de lumière, par exemple du type « guide d'ondes », par exemple un matériau collecteur de lumière luminescent comme les films polymères à base de polycarbonate commercialisés par la société BAYER sous la dénomination LISA®,
- un film multicouche interférentiel,
- une structure à effets optiques variables à base de pigments interférentiels ou de cristaux liquides,
- une couche biréfringente ou polarisante,
- une structure de diffraction,
- une image embossée,
- des moyens produisant un "effet de moiré", un tel effet pouvant par exemple faire apparaître un motif produit par la superposition de deux éléments de sécurité sur le document, par exemple par le rapprochement de lignes de deux éléments de sécurité,
- un élément réfractif partiellement réfléchissant,
- une grille lenticulaire transparente,
- une lentille, par exemple une loupe,
- un filtre coloré.
- un autre foil métallisé, goniochromatique ou holographique,
- une couche à effet optique variable à base de pigments interférentiels ou de cristaux liquides,
- un élément de sécurité plat et de format relativement petit tel qu'une planchette, visible ou non visible, notamment luminescent, avec ou sans dispositif électronique,
- des particules ou agglomérats de particules de pigments ou colorants de type HI-LITE, visibles ou non visibles, notamment luminescents,
- des fibres de sécurité, notamment métalliques, magnétiques (à magnétisme doux et/ou dur), ou absorbantes, ou excitables aux ultraviolets, le visible ou l'infrarouge, et en particulier le proche infrarouge (NIR),
- une sécurité lisible automatiquement ayant des caractéristiques spécifiques et mesurables de luminescence (par exemple fluorescence, phosphorescence), d'absorption de la lumière (par exemple ultraviolet, visible ou infrarouge), d'activité Raman, de magnétisme, d'interaction micro-ondes, d'interaction aux rayons X ou de conductivité électrique,
- des réactifs d'infalsification, par exemple du dipyridyle avec des ions ferriques qui, lors d'une tentative de falsification par un réducteur, sont réduits en ions ferreux et font apparaître une couleur rouge,
- un réactif tel que de l'iodate de potassium susceptible de former une marque visible et colorée lors d'une tentative de falsification.

Un ou plusieurs éléments de sécurité tels que définis plus haut peuvent être présents dans le document et/ou dans une ou plusieurs couches constitutives du document ou dans un ou plusieurs éléments de sécurité incorporés au document et/ou à une ou plusieurs couches constitutives du document, comme par exemple un fil, une fibre ou une planchette.

L'une au moins des couches constitutives du document peut aussi comporter un élément de sécurité de premier niveau tel qu'un filigrane ou un pseudo-filigrane se superposant au moins partiellement à une région translucide du document.

L'expression « comportant » doit se comprendre comme étant synonyme de « comportant au moins un », sauf si le contraire est spécifié.

## Revendications

1. Insert plat (1) destiné à être inséré dans un document de sécurité, comprenant un support fibreux (2) constitué en une seule couche muni d'une cavité (5) et un dispositif électronique (3) à communication sans contact logé dans ladite cavité, ladite cavité est débouchante sur une seule face du support fibreux (2) et elle comprend en section transversale un épaulement périphérique (13) pour loger ledit dispositif électronique dans ladite cavité sans générer de surépaisseur de l'insert, ledit support fibreux (2) comprenant des fibres synthétiques.

2. Insert selon la revendication 1, dans lequel le dispositif électronique est une puce module (3) comprenant une puce encapsulée (10) et un support de connexion (11) sur lequel repose la puce encapsulée pour une connexion entre ladite puce et une antenne (4), le support de connexion étant disposé dans ledit épaulement périphérique (13) de la cavité (5) et la puce encapsulée étant disposée dans un fond (12) de la cavité,
le dispositif électronique étant notamment choisi parmi les puces modules du type MOA2, MOB2, MOA4, MOB4, MOA6, MOB6, MCC2, MCC8, CID, Cubit, IOA2, EOA2, EOA8, EOA9, FCP3 et NSL-1 micromodules.

3. Insert selon la revendication 2, **caractérisé en ce qu'**il comprend une antenne filaire (4) ou sérigraphiée disposée sur la face du support sur laquelle débouche la cavité (5), la dite antenne étant munie de deux extrémités (6,7) connectées au support de connexion pour une communication sans contact.

4. Insert selon l'une des revendications précédentes, dans lequel le support fibreux (2) est formé d'au moins 30 % de fibres naturelles telles que des fibres cellulosiques et/ou des fibres de coton avec une proportion de fibres courtes moins élevées que de fibres longues,
le support fibreux comprenant notamment en outre un liant choisi parmi les polymères thermoplastique de Tg compris entre -25 °C et 40°C, ledit liant étant notammentchoisi parmi un copolymère styrène butadiène, un polymère acrylique, un acétate de vinyle et leurs copolymères, un latex, un composé d'amidon, un composé de charge minérale ou un mélange de ces derniers.

5. Insert selon l'une des revendications précédentes, dans lequel le support fibreux comporte un agent assouplissant choisi parmi la glycérine, l'urée ou l'urée nitrate.

6. Insert selon l'une des revendications précédentes, dans lequel ledit support fibreux comprend entre 8 et 15 % de fibres synthétiques, en masse dans une base fibreuse du support fibreux,
, les fibres synthétiques étant notamment choisies parmi des matières thermoplastiques telles qu'un polyamide, un polyester, une polyoléfine et/ou un mélange de telles fibres.

7. Insert selon l'une des revendications précédentes, dans lequel ledit support fibreux comprend une charge choisie parmi des charges minérales, notamment les carbonates, en particulier de calcium, le talc, le kaolin, l'hydrate d'alumine, le dioxyde de titane, le silicate de sodium et leurs mélanges, la charge étant de préférence une charge absorbante ayant une capacité d'absorption supérieur ou égal à 30 ml/100g.

8. Document de sécurité tel qu'un passeport, une carte d'identité, un permis de conduire, une carte à jouer ou à collectionner interactive, un moyen de paiement, notamment une carte de paiement, un bon d'achat ou un voucher, une carte de transport, une carte de fidélité, une carte de prestation ou une carte d'abonnement, incluant un insert selon l'une des revendications précédentes.

9. Procédé pour fabriquer un insert plat destiné à être inséré dans un document de sécurité, le procédé comprend les étapes consistant à :
- fournir un support fibreux (2), comprenant des fibres synthétiques,
- former une cavité (5) dans ledit support par compression au moyen d'une pièce (20) présentant un épaulement de sorte que ladite cavité est débouchante sur une seule face du support et qu'elle présente en section transversale un épaulement périphérique (13),
- loger un dispositif électronique (3) dans ladite cavité sans générer de surépaisseur de l'insert (1).

10. Procédé selon la revendication 9, **caractérisé en ce que** l'étape de formation de ladite cavité (5) dans ledit support fibreux (2) est réalisée par compressions répétées à une fréquence ultrasonore au moyen de la pièce (20) présentant un épaulement,
ou par thermocompression ou par emboutissage.

11. Procédé selon la revendication 9 ou 10,, **caractérisé en ce qu'**il comprend une étape consistant à fournir un dispositif électronique qui est une puce module (3) comprenant une puce encapsulée (10) et un support de connexion (11) sur lequel repose la puce encapsulée pour la connexion entre ladite puce et une antenne, et **en ce qu'**il comprend une étape consistant à disposer le support de connexion (11) dans ledit épaulement périphérique (13) de la cavité (5) et la puce encapsulée dans un fond (12) de la cavité.

12. Procédé selon l'une des revendications 9 à 11, **caractérisé en ce qu'**il comprend une étape consistant à disposer une antenne (4) filaire ou sérigraphiée sur la face du support sur laquelle débouche la cavité, ladite antenne étant munie de deux extrémités connectées au support de connexion (11) pour une communication sans contact.

13. Procédé selon l'une des revendications 9 à 12, dans lequel on fournit le support fibreux avec au moins 30 % de fibres naturelles telles que des fibres cellulosiques et/ou des fibres de coton avec une proportion de fibres courtes moins élevées que de fibres longues,
et dans lequel on fournit notamment le support fibreux avec un liant choisi parmi les polymères thermoplastique de Tg compris entre -25 °C et 40°C, ledit liant étant choisi parmi un copolymère styrène butadiène, un polymère acrylique, un acétate de vinyle et leurs copolymères, un latex, un composé d'amidon, un composé de charge minérale ou un mélange de ces derniers.

14. Procédé selon l'une des revendications 9 à 13, dans lequel on fournit le support fibreux avec un agent assouplissant choisi parmi la glycérine, l'urée ou l'urée nitrate et/ou on fournit le support fibreux avec une charge choisie parmi des charges minérales, notamment les carbonates, en particulier de calcium, le talc, le kaolin, l'hydrate d'alumine, le dioxyde de titane, le silicate de sodium et leurs mélanges, la charge étant de préférence une charge absorbante ayant une capacité d'absorption supérieur ou égal à 30 ml/100g.

15. Procédé selon l'une des revendications 9 à 14, dans lequel on fournit le support fibreux avec entre 8 et 15 % de fibres synthétiques en masse dans la base fibreuse du support fibreux, procédé
dans lequel on fournit notamment des fibres synthétiques choisies parmi des matières thermoplastiques telles qu'un polyamide, un polyester, une polyoléfine et/ou un mélange de telles fibres.

## Patentansprüche

1. Flacheinlage (1) zum Einlegen in ein Sicherheitsdokument, umfassend einen faserigen Träger (2), der von einer einzigen Schicht gebildet ist, mit einer Vertiefung (5) und einer elektronischen Vorrichtung (3) für kontaktlose Kommunikation, die in der Vertiefung aufgenommen ist, wobei die Vertiefung auf nur einer Seite des faserigen Trägers (2) ausmündet und im Querschnitt einen umlaufenden Absatz (13) umfasst, um die elektronische Vorrichtung (3) in der Vertiefung aufzunehmen, ohne eine Überdicke der Einlage zu erzeugen, wobei der faserige Träger (2) synthetische Fasern enthält.

2. Einlage nach Anspruch 1, wobei die elektronische Vorrichtung ein Chipmodul (3) ist, das einen gekapselten Chip (10) und einen Verbindungsträger (11) umfasst, auf dem der gekapselte Chip (10) für eine Verbindung zwischen dem Chip und der Antenne (4) aufliegt, wobei der Verbindungsträger in dem umlaufenden Absatz (13) der Vertiefung (5) angeordnet ist und wobei der gekapselte Chip in einem Boden (12) der Vertiefung angeordnet ist, wobei die elektronische Vorrichtung insbesondere ausgewählt ist aus den Chipmodulen des Typs MOA2, MOB2, MOA4, MOB4, MOA6, MOB6, MCC2, MCC8, CID, Cubit, IOA2, EOA2, EOA8, EOA9, FCP3 und NSL-1 Mikromodule.

3. Einlage nach Anspruch 1, **dadurch gekennzeichnet, dass** sie eine verdrahtete oder siebgedruckte Antenne (4) umfasst, die auf der Seite des Trägers angeordnet ist, auf der die Vertiefung (5) ausmündet, wobei die Antenne mit zwei Enden (6, 7) versehen ist, die mit dem Verbindungsträger für eine kontaktlose Kommunikation verbunden sind.

4. Einlage nach einem der vorhergehenden Ansprüche, wobei der faserige Träger (2) zu mindestens 30 % aus Naturfasern gebildet ist, wie zellulosehaltige Fasern und/oder Baumwollfasern, mit einem geringeren Anteil an kurzen Fasern als an langen Fasern,
wobei der faserige Träger insbesondere ferner ein Bindemittel enthält, das ausgewählt ist aus den thermoplastischen Polymeren mit einer Glasübergangstemperatur Tg zwischen -25 °C und 40 °C, wobei das Bindemittel insbesondere ausgewählt ist aus einem Styrol-Butadien-Copolymer, einem Acrylpolymer, einem Vinylacetat und deren Copolymeren, einem Latex, einer Stärkeverbindung, einer mineralischen Füllstoffverbindung oder einem Gemisch aus diesen letzten.

5. Einlage nach einem der vorhergehenden Ansprüche, wobei der faserige Träger einen Weichmacher aufweist, der ausgewählt ist aus Glycerin, Harnstoff oder Harnstoffnitrat.

6. Einlage nach einem der vorhergehenden Ansprüche, wobei der faserige Träger zwischen 8 und 15 % synthetische Fasern, bezogen auf die Masse, in einer faserigen Basis des faserigen Trägers enthält,
wobei die synthetischen Fasern insbesondere ausgewählt sind aus den thermoplastischen Materialien, wie einem Polyamid, einem Polyester, einem Polyolefin und/oder einem Gemisch aus derartigen Fasern.

7. Einlage nach einem der vorhergehenden Ansprüche, wobei der faserige Träger einen Füllstoff enthält, der ausgewählt ist aus den mineralischen Füllstoffen, insbesondere den Carbonaten, insbesondere Calcium, Talk, Kaolin, Aluminiumoxidhydrat, Titandioxid, Natriumsilikat und Gemischen davon, wobei der Füllstoff vorzugsweise ein absorbierender Füllstoff ist, der ein Absorptionsvermögen größer oder gleich 30 ml/100 g hat.

8. Sicherheitsdokument, wie ein Reisepass, ein Personalausweis, ein Führerschein, eine interaktive Spiel-oder Sammelkarte, ein Zahlungsmittel, insbesondere eine Zahlkarte, ein Einkaufsgutschein oder ein Voucher, ein Fahrausweis, eine Kundenkarte, ein Dienstleistungsausweis oder ein Abonnentenausweis, enthaltend eine Einlage nach einem der vorhergehenden Ansprüche.

9. Verfahren zum Herstellen einer Flacheinlage zum Einlegen in ein Sicherheitsdokument, wobei das Verfahren die folgenden Schritte umfasst:
- Bereitstellen eines faserigen Trägers (2), der synthetische Fasern enthält,
- Bilden einer Vertiefung (5) in dem Träger durch Kompression mittels eines Teils (20) mit einem Absatz, so dass die Vertiefung auf nur einer Seite des faserigen Trägers ausmündet und dass sie im Querschnitt einen umlaufenden Absatz (13) aufweist,
- Aufnehmenlassen einer elektronischen Vorrichtung (3) in der Vertiefung, ohne eine Überdicke der Einlage (1) zu erzeugen.

10. Verfahren nach Anspruch 9, **dadurch gekennzeichnet, dass** der Schritt des Bildens der Vertiefung (5) in dem faserigen Träger (2) durch wiederholte Kompressionen bei einer Ultraschallfrequenz mittels des Teils (20), das einen Absatz aufweist, oder durch Thermokompression oder durch Tiefziehen ausgeführt wird.

11. Verfahren nach Anspruch 9 oder 10, **dadurch gekennzeichnet, dass** es einen Schritt umfasst, der darin besteht, eine elektronische Vorrichtung bereitzustellen, die ein Chipmodul (3) ist, das einen gekapselten Chip (10) und einen Verbindungsträger (11) umfasst, auf dem der gekapselte Chip (10) für die Verbindung zwischen dem Chip und einer Antenne aufliegt, und dass es einen Schritt umfasst, der darin besteht, den Verbindungsträger (11) in dem umlaufenden Absatz (13) der Vertiefung (5) und den gekapselten Chip (10) in einem Boden (12) der Vertiefung anzuordnen.

12. Verfahren nach einem der Ansprüche 9 bis 11, **dadurch gekennzeichnet, dass** es einen Schritt umfasst, der darin besteht, eine verdrahtete oder siebgedruckte Antenne (4) auf der Seite des Trägers anzuordnen, auf der die Vertiefung (5) ausmündet, wobei die Antenne mit zwei Enden versehen ist, die mit dem Verbindungsträger (11) für eine kontaktlose Kommunikation verbunden sind.

13. Verfahren nach einem der Ansprüche 9 bis 12, bei dem der faserige Träger mit mindestens 30 % Naturfasern bereitgestellt wird, wie zellulosehaltige Fasern und/oder Baumwollfasern, mit einem geringeren Anteil an kurzen Fasern als an langen Fasern,
und wobei insbesondere der faserige Träger mit einem Bindemittel bereitgestellt wird, das ausgewählt ist aus den thermoplastischen Polymeren mit einer Glasübergangstemperatur Tg zwischen -25 °C und 40 °C, wobei das Bindemittel ausgewählt ist aus einem Styrol-Butadien-Copolymer, einem Acrylpolymer, einem Vinylacetat und deren Copolymeren, einem Latex, einer Stärkeverbindung, einer mineralischen Füllstoffverbindung oder einem Gemisch aus diesen letzten.

14. Verfahren nach einem der Ansprüche 9 bis 13, bei dem der faserige Träger mit einem Weichmacher bereitgestellt wird, der ausgewählt ist aus Glycerin, Harnstoff oder Harnstoffnitrat, und/oder der faserige Träger mit einen Füllstoff bereitgestellt wird, der ausgewählt ist aus den mineralischen Füllstoffen, insbesondere den Carbonaten, insbesondere Calcium, Talk, Kaolin, Aluminiumoxidhydrat, Titandioxid, Natriumsilikat und Gemischen davon, wobei der Füllstoff vorzugsweise ein absorbierender Füllstoff ist, der ein Absorptionsvermögen größer oder gleich 30 ml/100 g hat.

15. Verfahren nach einem der Ansprüche 9 bis 14, bei dem der faserige Träger mit zwischen 8 und 15 % synthetische Fasern, bezogen auf die Masse, in einer faserigen Basis des faserigen Trägers bereitgestellt wird, wobei bei dem Verfahren
insbesondere synthetischen Fasern bereitgestellt werden, die ausgewählt sind aus den thermoplastischen Materialien, wie einem Polyamid, einem Polyester, einem Polyolefin und/oder einem Gemisch aus derartigen Fasern.

## Claims

1. Flat insert (1) intended to be inserted into a security document, comprising a fibrous support (2) consisting of a single layer provided with a cavity (5) and a contactless communication electronic device (3) housed in said cavity, said cavity opens out onto a single face of the fibrous support (2) and it comprises, in cross section, a peripheral shoulder (13) to house said electronic device in said cavity without increasing the thickness of the flat insert, said fibrous support (2) comprising synthetic fibres,

2. Flat insert according to claim 1, in which the electronic device is a module chip (3) comprising an encapsulated chip (10) and a connection support (11) on which the encapsulated chip rests for a connection between said encapsulated chip and an antenna (4), the connection support being positioned in said peripheral shoulder (13) of the cavity (5) and the encapsulated chip being positioned in a bottom (12) of the cavity,
the electronic device is selected from the module chips of the MOA2, MOB2, MOA4, MOB4, MOA6, MOB6, MCC2, MCC8, CID, Cubit, IOA2, EOA2, EOA8, EOA9, FCP3 and NSL-1 micromodules types.

3. Flat insert according to claim 2, **characterized in that** it comprises a wired or screen-printed antenna (4) positioned on the face of the fibrous support on which the cavity (5) opens out, said wired or screen-printed antenna being provided with two ends (6, 7) connected to the connection support for a contactless communication.

4. Flat insert according to one of the preceding claims, in which the fibrous support (2) is formed by at least 30% natural fibres such as cellulosic fibres or cotton fibres with a lower proportion of short fibres than of long fibres, the fibrous support further comprising a binder selected from the thermoplastic polymers with a Tg of between -25°C and 40°C, said binder being selected from a butadiene styrene copolymer, an acrylic polymer, a vinyl acetate and their copolymers, a latex, a starch compound, a mineral filler compound or a mixture of the latter.

5. Flat insert according to one of the preceding claims, in which the fibrous support includes a softening agent selected from glycerin, urea or urea nitrate.

6. Flat insert according to one of the preceding claims, in which said fibrous support comprises between 8 and 15% synthetic fibres, by weight, in a fibrous base of the fibrous support, the synthetic fibres being selected from thermoplastic materials such as a polyamide, a polyester, a polyolefin and/or a mixture of the latter.

7. Flat insert according to one of the preceding claims, in which said fibrous support comprises a filler selected from mineral fillers, including carbonates, in particular calcium carbonate, talc, kaolin, aluminium hydrate, titanium dioxide, sodium silicate and their mixtures, the filler being preferably an absorbing filler having an absorption capacity greater or equal to 30ml/100g.

8. Security document such as a passport, an identity card, a driver licence, a playing or trading interactive card, a mean of payment, especially a credit card, a good purchase or a voucher, a loyalty card, a provision card or a subscription card, including a flat insert according to one of the preceding claims.

9. Method for fabricating a flat insert intended to be inserted in a security document, the method comprising steps consisting in:
- providing a fibrous support (2), comprising synthetic fibres,
- forming a cavity (5) in said fibrous support by compression by means of a part (20) having a shoulder so that said cavity opens out onto a single face of the fibrous support and that it has, in cross section, a peripheral shoulder (13),
- housing an electronic device (3) in said cavity without increasing the thickness of the flat insert (1).

10. Method according to claim 9, **characterized in that** the step for forming said cavity (5) in said fibrous support (2) is performed by repeated compressions at an ultrasound frequency by means of the part (20) having a shoulder, or by thermocompression or by stamping.

11. Method according to one of claims 9 or 10, **characterized in that** it comprises a step consisting in providing an electronic device which is a module chip (3) comprising an encapsulated chip (10) and a connection support (11) on which the encapsulated chip rests for the connection between said encapsulated chip and an antenna, and **in that** it comprises a step consisting in positioning the connection support (11) in said peripheral shoulder (13) of the cavity (5) and the encapsulated chip in a bottom (12) of the cavity.

12. Method according to claims 9 to 11, **characterized in that** it comprises a step consisting in positioning a wired or screen-printed antenna (4) on the face of the fibrous support on which the cavity opens out, said wired or screen-printed antenna being provided with two ends connected to the connection support (11) for a contactless communication.

13. Method according to claims 9 to 12, in which the fibrous support is provided with at least 30% natural fibres such as cellulosic fibres or cotton fibres with a lower proportion of short fibres than of long fibres, the fibrous support is further provided with a binder selected from the thermoplastic polymers with a Tg of between -25°C and 40°C, said binder being selected from a butadiene styrene copolymer, an acrylic polymer, a vinyl acetate and their copolymers, a latex, a starch compound, a mineral filler compound or a mixture of the latter.

14. Method according to claims 9 to 13, in which the fibrous support is provided with a softening agent selected from glycerin, urea or urea nitrate and/or the fibrous support is provided with a filler selected from mineral fillers, including carbonates, in particular calcium carbonate, talc, kaolin, aluminium hydrate, titanium dioxide, sodium silicate and their mixtures, the filler being preferably an absorbing filler having an absorption capacity greater or equal to 30ml/100g.

15. Method according to claims 9 to 14, in which the fibrous support is provided with between 8 and 15% synthetic fibres, by weight, in the fibrous base of the fibrous support, the synthetic fibres being selected from thermoplastic materials such as a polyamide, a polyester, a polyolefin and/or a mixture of the latter.
